# FASCICULE DE BREVET EUROPEEN

(11) **EP 1 006 573 B1**
(45) Date de publication et mention de la délivrance du brevet: **29.08.2007**
(21) Numéro de dépôt: 99410172.3
(22) Date de dépôt: 29.11.1999
(51) Int. Cl.: H01L 21/8249

(54) **Procédé de fabrication de circuits intégrés BICMOS sur un substrat CMOS classique**
Herstellungsverfahren für integrierte BiCMOS Schaltkreise auf einem gewöhnlichen CMOS Substrat
Method for manufacturing integrated BiCMOS circuits on a common CMOS substrate

(30) Priorité: 30.11.1998 FR 9815239
(43) Date de publication de la demande: 07.06.2000
(73) Titulaire: STMicroelectronics S.A., 92120 Montrouge (FR); FRANCE TELECOM, 75015 Paris (FR)
(72) Inventeur: Laurens, Michel, 38120 Saint Egreve (FR)
(74) Mandataire: de Beaumont, Michel

(56) Documents cités:
- EP-A- 0 281 235
- EP-A- 0 418 422
- EP-A- 0 746 038
- EP-A- 0 769 810
- US-A- 4 812 890
- US-A- 5 557 131
- CHANTRE A ET AL: "A high performance low complexity SiGe HBT for BiCMOS integration" PROCEEDINGS OF THE 1998 BIPOLAR/BICMOS CIRCUITS AND TECHNOLOGY MEETING (CAT. NO.98CH36198), PROCEEDINGS OF THE 1998 BIPOLAR/BICMOS CIRCUITS AND TECHNOLOGY MEETING, MINNEAPOLIS, MN, USA, 27-29 SEPT. 1998, pages 93-96, XP002132176 1998, Piscataway, NJ, USA, IEEE, USA ISBN: 0-7803-4497-9
- MOUIS M ET AL: "VLSI integration of SiGe epitaxial base bipolar transistors" 1998 URSI INTERNATIONAL SYMPOSIUM ON SIGNALS, SYSTEMS, AND ELECTRONICS. CONFERENCE PROCEEDINGS (CAT. NO.98EX167), 1998 URSI INTERNATIONAL SYMPOSIUM ON SIGNAL, SYSTEMS, AND ELECTRONICS. CONFERENCE PROCEEDINGS, PISA, ITALY, 29 SEPT.-2 OCT. 1998, pages 50-55, XP002132177 1998, New York, NY, USA, IEEE, USA ISBN: 0-7803-4900-8
- NGUYEN-NGOC D ET AL: "A 200 MM SIGE-HBT BICMOS TEHCNOLOGY FOR MIXED SIGNAL APPLICATIONS" PROCEEDINGS OF THE 1995 BIPOLAR/BICMOS CIRCUITS AND TECHNOLOGY MEET, MINNEAPOLIS, OCT. 1 - 3, 1995, no. MEETING 10, 1 octobre 1995 (1995-10-01), pages 89-92, XP000630205 INSTITUTE OF ELECTRICAL AND ELECTRONICS ENGINEERS ISBN: 0-7803-2779-9
- HARAME D.L. ET AL: 'si/sige epitaxial-base transistors, part ii process integration and analog applications' IEEE TRANSACTIONS ON ELECTRON DEVICES vol. 42, no. 3, 01 Mars 1995, IEEE SERVICE CENTER, PISACATAWAY, NJ, US, pages 469 - 482, XP000493959

## Description

La présente invention concerne la fabrication de circuits intégrés et plus particulièrement de circuits dits BICMOS, c'est-à-dire de circuits comprenant des transistors bipolaires et des transistors MOS complémentaires.

Dans de telles structures, on s'intéresse généralement plus particulièrement à la qualité des transistors bipolaires de type NPN, les transistors PNP étant par nature moins rapides que les transistors NPN. Ces transistors NPN doivent toujours être de qualité convenable. On distingue toutefois une première et une deuxième catégorie de circuits intégrés BICMOS. Dans la première catégorie, l'accent est essentiellement mis sur les performances des transistors bipolaires NPN qui doivent permettre des fonctionnements à des fréquences pouvant aller jusqu'à quelques gigahertz. Dans la deuxième catégorie, les circuits comprennent des transistors MOS assurant essentiellement les fonctions logiques et des transistors bipolaires destinés essentiellement aux amplificateurs d'entrée/sortie et à la réalisation de quelques fonctions analogiques. On se placera ici plutôt dans ce dernier cas, dans lequel l'essentiel d'un circuit intégré est constitué de transistors CMOS et où les transistors bipolaires NPN doivent être de bonne qualité sans nécessairement devoir fonctionner à de très hautes fréquences de l'ordre du gigahertz.

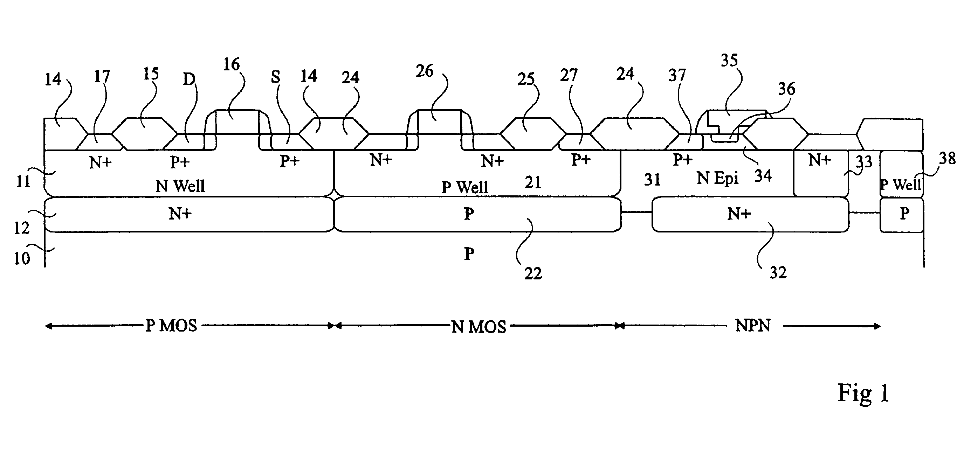

La figure 1 est une vue en coupe schématique d'une portion d'un circuit intégré BICMOS classique. La partie gauche de la figure comporte un transistor MOS à canal P (PMOS), la partie centrale de la figure contient un transistor MOS à canal N (NMOS) et la partie droite de la figure contient un transistor bipolaire de type NPN. La structure est formée à partir d'une plaquette de silicium monocristalline 10 de type P sur laquelle est formée une couche épitaxiée de type N. Des couches enterrées sont formées à l'interface entre le substrat de silicium et la couche épitaxiée.

Le transistor MOS à canal P est formé dans un caisson 11 de type N (Nwell), de préférence formé au-dessus d'une couche enterrée 12 fortement dopée de type N elle-même formée à la partie supérieure du substrat 10. Le caisson N est délimité latéralement et en surface par des zones d'isolement, par exemple un oxyde épais 14 formé par les techniques dites LOCOS. Une autre région d'oxyde épais 15 délimite une portion du caisson N 11. Dans la partie principale du caisson N est formé un transistor MOS à canal P comprenant de part et d'autre d'une grille 16 des régions de drain D et de source S. De façon classique, cette structure comporte des espaceurs et des zones d'extension de drain et de source à faible niveau de dopage (LDD) . Une zone 17 fortement dopée de type N dans la portion de caisson N délimitée par l'oxyde épais 15 permet de reprendre un contact sur le caisson.

Le transistor MOS à canal N est formé de façon complémentaire dans un caisson 21 de type P (Pwell) formé sur une couche enterrée 22. Le caisson P est délimité par un oxyde épais 24 et un oxyde épais 25 délimite une portion de caisson. Le transistor à canal N est formé dans la partie principale du caisson de part et d'autre d'une grille isolée 26. Un contact 27 fortement dopé de type P permet de connecter le caisson P.

Le transistor bipolaire de type NPN est formé dans une zone 31 de la couche épitaxiale de type N située au-dessus d'une couche enterrée 32 fortement dopée de type N. La région 31 correspond au collecteur et la région 32 à une zone de reprise de contact de collecteur qui est connectée à la surface du circuit intégré par l'intermédiaire d'un puits collecteur fortement dopé de type N 33. Une zone de base 34 est formée par implantation et/ou diffusion à la surface de la couche épitaxiée de type N. Au-dessus de cette zone de base, une couche de silicium polycristallin 35 fortement dopée de type N permet de créer par diffusion une région d'émetteur 36 dans la base 34. Une zone 37 fortement dopée de type P est disposée latéralement par rapport à la région de base intrinsèque 34, par exemple de la façon représentée dans la figure et permet une reprise de contact de base. En outre, la portion 31 de couche épitaxiée de type N dans laquelle est formée le transistor bipolaire doit être isolée des autres composants de la structure formée dans la zone épitaxiée de type N ou dans un caisson de type N. Ainsi, la région 31 de type N doit être entourée d'un caisson de type P. Ce caisson de type P correspond éventuellement comme cela est représenté à gauche du transistor bipolaire à un caisson dans lequel est formé un transistor MOS à canal N ou bien, comme cela est représenté par la région 38 à la droite de la figure, à un mur d'isolement spécifique 38 correspondant à une diffusion réalisée en même temps que les caissons de type P.

Un procédé de fabrication de la structure illustrée en figure 1 réalisée sur un substrat de type P (10) comprend les étapes principales suivantes :
implantation des régions enterrées de type N (12, 32);
implantation des régions enterrées de type P (22) ;
croissance d'une couche épitaxiale ayant par exemple une épaisseur de l'ordre de 1 µm et un niveau de dopage de l'ordre de 10¹⁶ atomes/cm³ ;
formation des régions d'oxyde épais d'isolement (14, 15, 24, 25) ;
implantation des caissons N (11) ;
implantation des puits collecteurs (33) ;
implantation des caissons P (21) (et des régions d'isolement P 38) ;
formation des grilles des transistors à effet de champ à canal N et à canal P ;
implantation des régions faiblement dopées (LDD) de type N puis implantation des régions faiblement dopées (LDD) de type P - avec chaque fois implantation simultanée de la prise de contact du caisson autre que celui dans lequel on fait les implantations de sources et de drains LDD ;
   (pour les opérations suivantes, les régions de transistors MOS sont masquées et on forme les transistors bipolaires)
implantation d'une région de base de type P (34) dans la zone épitaxiée (31) ;
masquage d'une zone d'émetteur et dépôt d'une couche de silicium polycristallin fortement dopée de type N (35) ;
délimitation de la couche (35) de contact d'émetteur ;
formation des espaceurs de grilles des transistors MOS et d'espaceurs latéraux autour de la zone de silicium polycristallin de contact d'émetteur ;
   (pour les opérations suivantes, les régions de transistors MOS et de transistors bipolaires sont traitées)
implantation des régions de type N de drain-source des transistors à canal N, de prise de contact des caissons N, et de contact de puits collecteurs ;
implantation des régions de type P de drain-source des transistors à canal P, de prise de contact de caisson P, et de prise de contact de base.

Ce procédé de fabrication dans un même substrat semiconducteur de transistors MOS complémentaires et de transistors bipolaires présente par rapport à un procédé classique de réalisation de circuit intégré comprenant uniquement des transistors MOS complémentaires notamment les différences suivantes :
- on utilise une épitaxie de type N sur un substrat de type P alors qu'un procédé classique de fabrication de transistors CMOS utilise une épitaxie de type P faiblement dopée sur un substrat de type P plus fortement dopé ;
- la formation de la couche épitaxiée est précédée de la formation de couches enterrées ;
- il existe une étape spécifique de dopage profond pour la formation des puits collecteur.

Ainsi, par rapport à un procédé classique de formation de transistors CMOS, le procédé décrit ci-dessus de fabrication d'un transistor BICMOS présente essentiellement l'inconvénient de nécessiter la formation de couches enterrées avant la formation d'une couche epitaxiée. Ceci augmente considérablement la durée et les coûts de fabrication. En effet, il est plus difficile en raison des problèmes d'exodiffusion de former une couche épitaxiée sur un substrat inhomogène comprenant des régions N⁺ et P⁺ que sur un substrat homogène. En outre, des fabricants de silicium proposent des substrats homogènes munis d'une couche épitaxiée et comme ils fabriquent de tels éléments en grande série, les coûts sont très compétitifs.

Un procédé de ce type est décrit dans un article de Harame et al., IEEE Transactions on Electron Devices, IEEE Inc., New York, pages 469-482, 1er mars 1995, XP000493959.

Cette complication du processus de fabrication est liée au fait que l'on souhaite pour un transistor bipolaire disposer au voisinage de la base d'une région de collecteur de type N faiblement dopée. En effet, ce faible dopage du collecteur au voisinage de la base contribue à conférer des caractéristiques de gain élevé et de bonne tenue en tension d'un transistor. Par contre, il convient que la zone faiblement dopée de collecteur ne soit pas trop étendue pour limiter la résistance d'accès au collecteur. C'est essentiellement en raison de ces deux considérations que les transistors NPN de circuits intégrés comportent de façon quasi-systématique des couches enterrées de type N⁺ sous une épitaxie de type N, la couche enterrée servant d'accès faiblement résistif à un collecteur faiblement dopé.

Ainsi, un objet de la présente invention est de prévoir un nouveau procédé de fabrication d'une structure de circuit intégré BICMOS.

Un autre objet de la présente invention est de prévoir un tel procédé dans lequel on limite le nombre d'étapes de fabrication.

Un autre objet de la présente invention est de prévoir un tel procédé qui permette l'obtention d'un transistor bipolaire NPN de bonne qualité.

Pour atteindre ces objets, la présente invention prévoit un procédé de fabrication d'un circuit intégré BICMOS tel que présenté en revendication 1.

Selon un mode de réalisation de la présente invention, l'épitaxie de base comprend en outre une étape d'épitaxie de silicium-germanium avec une proportion de germanium de l'ordre de 10 à 15 %, cette phase étant réalisée après la phase de dépôt de silicium intrinsèque.

Selon un mode de réalisation de la présente invention, le caisson de collecteur est formé en même temps que les caissons des transistors MOS à canal P.

Selon un mode de réalisation de la présente invention, la couche de silicium d'amorçage est déposée sur une couche d'oxyde de silicium.

Selon un mode de réalisation de la présente invention, le caisson a un niveau de dopage superficiel de l'ordre de 10¹⁷ atomes/cm³.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment illustre une portion d'un circuit intégré BICMOS classique comprenant un transistor PMOS, un transistor NMOS et un transistor NPN ;
les figures 2A à 2C illustrent des étapes successives de fabrication d'un transistor bipolaire dans un circuit intégré BICMOS selon la présente invention ;
la figure 3 représente une vue de dessus de masques utilisés pour former un transistor bipolaire obtenu par le procédé selon la présente invention ;
la figure 4A représente une vue en coupe selon la ligne A-A du transistor bipolaire obtenu avec les masques de la figure 3 ;
la figure 4B représente une vue en coupe selon la ligne B-B du transistor bipolaire obtenu avec les masques de la figure 3 ; et
les figures 5A et 5B représentent les concentrations de dopants avant et après recuit en fonction de l'épaisseur dans la zone émetteur/base/collecteur d'un transistor bipolaire selon la présente invention.

Comme cela est classique dans le domaine de la représentation des circuits intégrés, les diverses figures ne sont pas tracées à l'échelle mais leurs dimensions ont été arbitrairement dilatées pour améliorer la lisibilité des dessins.

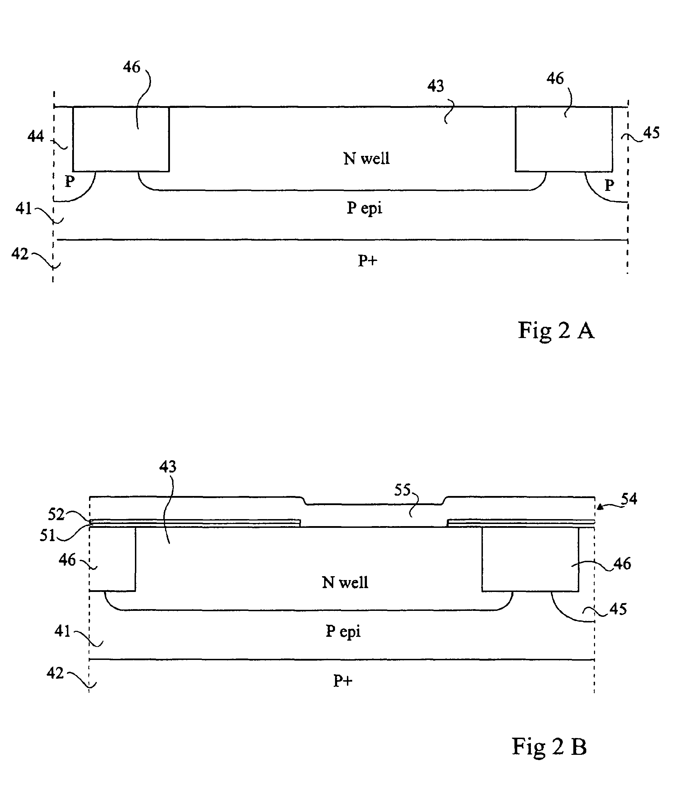

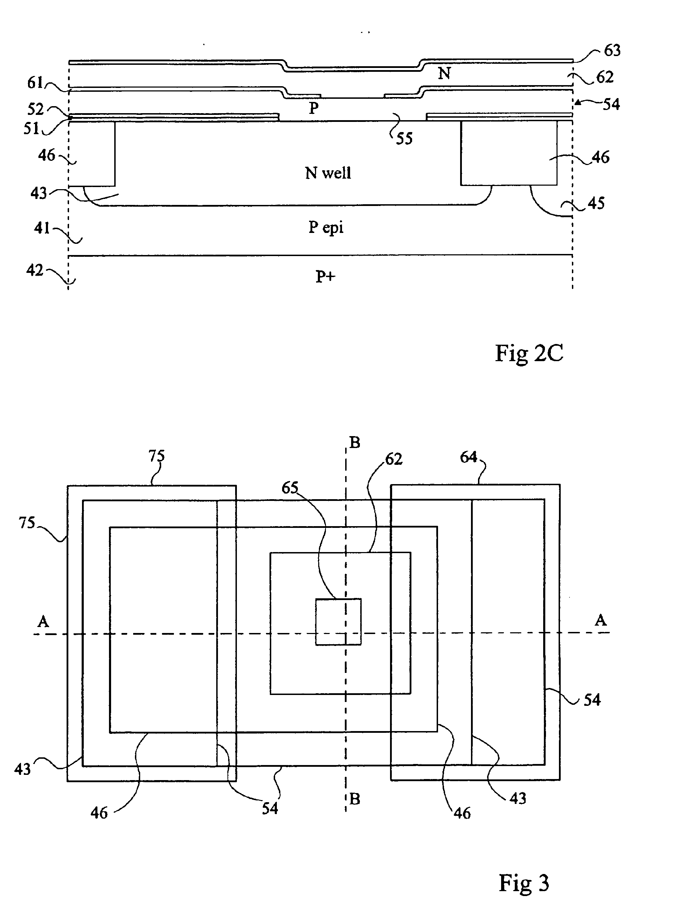

Les figures 2A et 2C illustrent des étapes successives de fabrication d'un transistor bipolaire selon la présente invention, étant entendu que ce transistor bipolaire est inclus dans un circuit intégré comprenant des transistors MOS à canal N et à canal P, comme cela a été décrit en relation avec la figure 1.

Selon un aspect de la présente invention, le circuit intégré BICMOS selon la présente invention est formé sur une couche 41 faiblement dopée de type P, directement formée par épitaxie sur un substrat de silicium monocristallin 42 plus fortement dopé de type P. Ainsi, on part d'une couche épitaxiée de type P- sur un substrat de type P⁺ comme cela est couramment utilisé pour la fabrication de circuits intégrés de type CMOS. Cette structure présente par rapport à celle décrite en relation avec la figure 1 l'avantage de ne pas comporter de couches enterrées entre le substrat monocristallin et la couche épitaxiée ce qui réduit fortement le nombre d'étapes de fabrication et donc le temps et le coût de fabrication. Les transistors MOS obtenus sont similaires à ceux représentés en figure 1 sauf qu'il n'est pas prévu sous les transistors MOS respectifs de couche enterrée de type N (12) ou P (22) et que les caissons N et P s'arrêtent dans la couche épitaxiée avant d'atteindre le substrat 42.

Un transistor bipolaire selon la présente invention est formé dans un caisson de type N 43, de préférence semblable aux caissons de type N dans lesquels sont formés les transistors MOS à canal P. On a représenté de part et d'autre du caisson N 43 des portions de caissons de type P 44 et 45 dans lesquels sont par exemple formés des transistors MOS à canal N semblables à celui formé dans le caisson 21 de la figure 1. Le caisson 43 est délimité superficiellement par un anneau d'oxyde épais 46. Dans le mode de réalisation représenté, l'anneau 46 est de type BOX, c'est-à-dire qu'il est constitué d'une couche d'oxyde disposée dans une rainure gravée dans le substrat. Ces rainures sont de préférence formées après fabrication des caissons N et P. Toutefois il ne s'agit là que d'un mode de réalisation de la présente invention et les zones d'oxyde épais 46 pourront correspondre à des oxydes formés par le procédé dit LOCOS ou tout autre procédé adapté.

A l'étape illustrée en figure 2B, on a successivement déposé sur l'ensemble de la structure une couche mince d'oxyde de silicium 51 et une couche de silicium polycristallin 52. On a formé une ouverture dans l'ensemble des couches 51, 52 au-dessus de la zone de collecteur 43. On a réalisé ensuite un dépôt épitaxial uniforme. Ce dépôt épitaxial 54 entraîne la formation d'une couche monocristalline 55 au-dessus de l'ouverture sur le silicium monocristallin de collecteur et d'une couche polycristalline au-dessus de la couche de silicium polycristallin 52.

Cette étape de dépôt épitaxial d'une couche de silicium constitue l'une des étapes fondamentales de la présente invention et est réalisée en plusieurs temps. Elle sera décrite plus en détail ci-après. On obtient ainsi une couche de silicium 54 dont la partie 55 située au-dessus de l'ouverture ménagée dans les couches 51, 52 constituera la région de base du transistor bipolaire NPN. On notera que ce dépôt épitaxial ne pose pas de problèmes particuliers car il est réalisé sur un support sensiblement homogène constitué par la couche de silicium polycristallin 52 dans laquelle sont ménagées de petites fenêtres. De plus, comme on le verra ci-après, ce dépôt est mince (épaisseur inférieure à 0,2 µm) par rapport à la couche épitaxiée de la figure 1 (épaisseur supérieure à 1 µm).

La figure 2C illustre des étapes de formation de l'émetteur du transistor NPN. On dépose d'abord sur l'ensemble de la couche 54 une couche isolante 61, éventuellement constituée d'un ensemble de plusieurs couches minces isolantes. On ouvre ensuite la couche 61 aux emplacements de l'émetteur par une gravure plasma suivie d'une gravure chimique. Après quoi, on dépose par voie chimique en phase vapeur une couche de silicium polycristallin 62 fortement dopée de type N. Cette couche de silicium polycristallin est destinée à constituer une source de dopants devant être diffusés dans la région de base 55 et à servir de reprise de contact d'émetteur. La couche de silicium polycristallin 62 est de préférence recouverte d'une couche de protection 63, par exemple en oxyde de silicium.

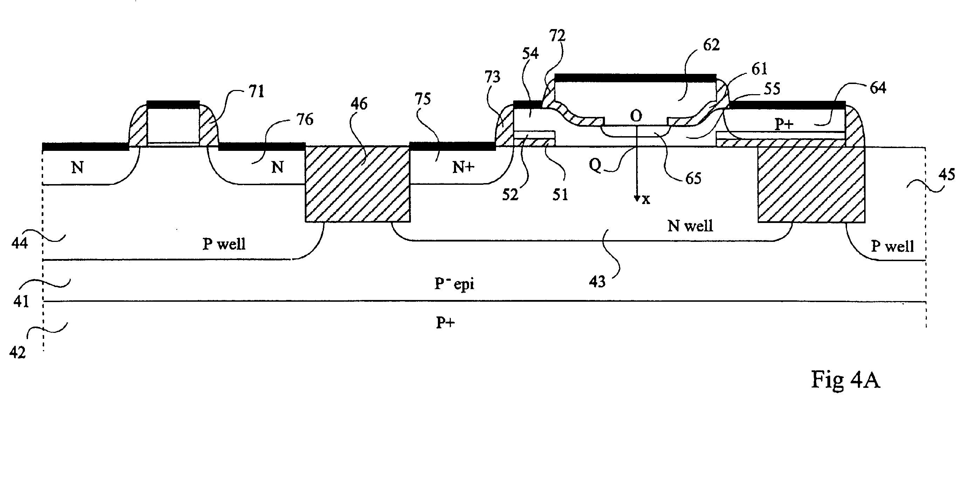

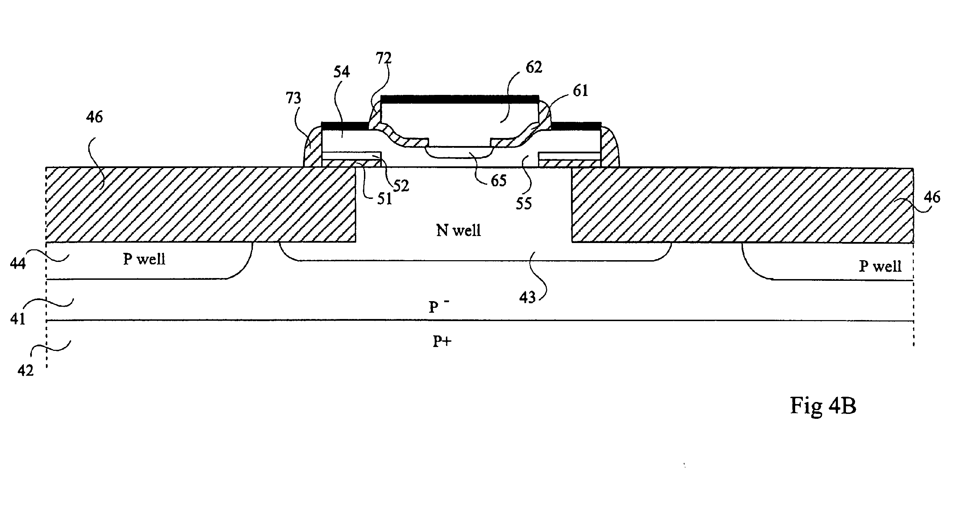

On prévoit ensuite des étapes de gravure du silicium polycristallin de contact d'émetteur 62, de gravure de la couche de silicium polycristallin 54 en dehors de la région de base 55, de dopage de type P d'une région de reprise de contact de base et de dopage de type N d'une région de reprise de contact de collecteur. Le résultat de ces étapes est illustré dans la vue de dessus de masques de la figure 3 et dans les vues en coupe selon les lignes A-A et B-B de cette figure 3, illustrées respectivement en figures 4A et 4B.

La figure 4A correspond à une vue en coupe prise dans le même plan que les figures 2A à 2C. Toutefois, dans cette vue en coupe, on a en outre représenté partiellement à gauche de la figure un transistor MOS à canal N réalisé à côté du transistor bipolaire selon la présente invention.

Comme on le voit en figure 4A, on a d'abord gravé la couche de silicium polycristallin d'émetteur 62 puis on a gravé la couche de silicium de base 54. On a laissé en place une partie en débordement 64 de la zone de silicium de base 54 au-dessus d'une région d'oxyde épais pour qu'elle constitue une zone de reprise de contact de base. On notera que le dopant N contenu dans la couche de silicium polycristallin 62 a légèrement diffusé dans la couche épitaxiée 55 pour former une zone d'émetteur 65. Après avoir découpé les couches 62 et 54, on forme des espaceurs simultanément du côté des transistors bipolaires et du côté des transistors MOS. On forme ainsi, du côté du transistor MOS à canal N représenté à la gauche de la figure des espaceurs 71 tandis que l'on forme des espaceurs 72 sur les bords de la couche de silicium polycristallin 62 et des espaceurs 73 sur les bords de la couche de silicium de base. L'espaceur 72 à droite en figure 4A sert à délimiter l'implantation P destinée à surdoper l'extension 64 de la couche de silicium de base pour former une zone de reprise de contact de base en même temps qu'on forme les drains et sources des transistors MOS à canal P. De même, l'espaceur 73 représenté en figure 4A à gauche de la couche de silicium de base sert à délimiter une implantation de type N⁺ de reprise de contact de collecteur 75 formée en même temps que les drains et sources 76 des transistors MOS à canal N. Ensuite, on pourra former sur toutes les régions de silicium apparentes un siliciure pour améliorer les reprises de contact.

Les figures 3 et 4B ne seront pas décrites plus en détail. Elles portent les mêmes références que la figure 4A et sont destinées à mieux faire comprendre la topologie du composant selon la présente invention et plus particulièrement des zones de reprise de contact de base et de collecteur. En figure 3, les divers masques sont désignés par le nom des zones qu'ils sont destinés à former. On notera qu'en raison de la présence des espaceurs 72 et 73, les masques 64 et 75 ne sont pas critiques.

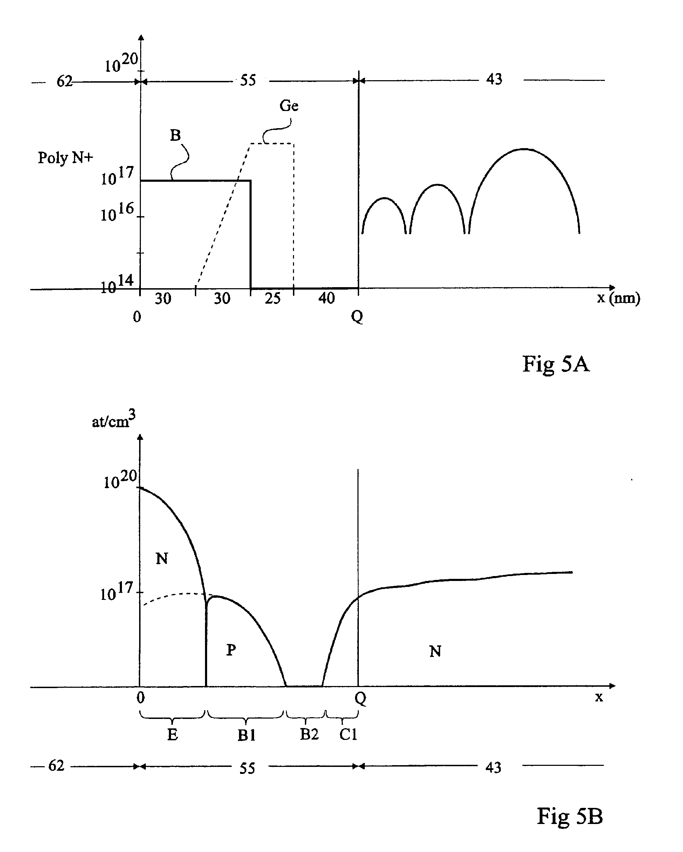

La figure 5A représente les profils d'implantation avant recuit transversalement à la région de collecteur-base-émetteur, selon l'axe 0x indiqué en figure 4A, c'est-à-dire en prenant pour origine la limite entre la zone épitaxiée 55 de silicium de base et la couche 62 de silicium polycristallin de contact d'émetteur, en direction de la couche 43 de collecteur. La figure 5B représente ces mêmes profils après recuit.

Tout d'abord, on notera que le collecteur 43, dans un mode de réalisation classique d'un caisson N de transistor PMOS résulte d'une triple implantation. Trois implantations successives sont réalisées à des énergies et doses décroissantes de sorte que le caisson N a, après recuit, comme cela est représenté en figure 5B, un profil de concentration sensiblement uniforme avec une concentration en surface de l'ordre de 10¹⁷ atomes/cm³.

Dans un mode de réalisation de la présente invention, la couche épitaxiée 54 est réalisée en quatre phases. Dans une première phase, on réalise une épitaxie de silicium pur, c'est-à-dire de silicium non dopé. Cette épitaxie s'étend par exemple sur une épaisseur d'environ 40 nm à partir de la surface Q du caisson N 43. Dans une deuxième phase, sur une épaisseur d'environ 25 nm, on réalise une épitaxie de silicium non dopé mais additionné d'environ 12 % de germanium. Dans une troisième phase, sur une épaisseur d'environ 30 nm, on continue l'épitaxie en réduisant progressivement la concentration de germanium pour arriver à une concentration nulle de germanium. Cette troisième phase d'épitaxie est réalisée en présence d'une source de bore de sorte que la concentration en bore soit de l'ordre de 10¹⁷ atomes/cm³. Enfin, la quatrième phase d'épitaxie est réalisée en présence de bore et en l'absence de germanium pour que la concentration en bore soit encore de l'ordre de 10¹⁷ atomes/cm³.

La figure 5B représente les profils obtenus après recuit. Au voisinage du point O, dans une zone E, les dopants de type N (arsenic) contenus dans le silicium polycristallin de la région de contact d'émetteur 62 diffusent dans la base en ayant une concentration maximum de l'ordre de 10¹⁹ à 10²⁰ atomes/cm³. On trouve ensuite une région B1 de type P qui correspond à la base intrinsèque. Au voisinage de la jonction base-émetteur, la concentration en dopants du type P est de l'ordre de 10¹⁷ atomes/cm³. C'est essentiellement dans cette région de base B1 que l'épitaxie a été réalisée en présence de germanium pour former une structure monocristalline silicium-germanium. On trouve ensuite une région B2 pratiquement non dopée, puis une région C1 dans laquelle des atomes de type N du collecteur ont diffusé dans la couche épitaxiée non dopée. Enfin, on trouve le caisson de collecteur 43.

Une des difficultés de réalisation du transistor selon la présente invention, résulte du fait que le caisson de collecteur 43 est identique aux caissons N utilisés pour la réalisation de transistors MOS de très petites dimensions. Ces caissons sont relativement fortement dopés (de l'ordre de 10¹⁷ atomes/cm³ en surface comme on l'a vu précédemment) . Ceci fournirait un très mauvais transistor bipolaire si on réalisait directement dans le caisson 43 une base diffusée ; ce transistor aurait à la fois un gain faible et une faible tension d'Early.

Ce problème est résolu selon un aspect de la présente invention en prévoyant comme on l'a indiqué précédemment une épitaxie réalisée en plusieurs phases. Selon un aspect de la présente invention, cette épitaxie comprend d'abord une couche de silicium monocristallin non dopée quasi-intrinsèque, suivie d'une couche de silicium monocristallin de base proprement dite de type P. Cette zone de silicium monocristallin non dopée correspond, après les recuits thermiques à une zone de collecteur très faiblement dopée au voisinage de la base ce qui permet d'obtenir un transistor à tension d'Early relativement élevée.

En outre, pour favoriser une valeur élevée du gain, on prévoit de préférence selon la présente invention une zone de base proprement dite constituée d'une matrice monocristalline silicium-germanium, ce qui a pour effet de diminuer la barrière de potentiel vue par les électrons pour passer de l'émetteur dans la base et donc d'obtenir un courant de collecteur plus fort pour un courant de base donné. Le fait que l'on puisse relever le gain également grâce à l'utilisation de germanium permet d'utiliser un dopage de base relativement élevé ce qui a pour effet, de façon connue, d'améliorer les caractéristiques du transistor, notamment en augmentant la tension d'Early du transistor.

La présente invention est susceptible de diverses variantes et modifications qui apparaîtront à l'homme de l'art. Par exemple, une fois qu'on a réalisé l'ouverture dans la couche 52, on peut, avant de produire une croissance épitaxiale, réaliser une implantation profonde de type N pour améliorer encore la conductivité du collecteur sous la jonction base-collecteur.

On notera donc que le transistor selon la présente invention réalise un bon compromis entre un gain élevé, une bonne tension d'Early et une faible résistance d'accès au collecteur. Cette résistance d'accès faible est liée au fait que la région de reprise de contact de collecteur 75 se trouve très proche de la région de base intrinsèque en raison des autoalignements utilisés dans la présente invention comme on l'a exposé précédemment. Par exemple, l'ouverture d'émetteur peut avoir une largeur de 0,35 µm, l'ouverture de base une largeur de l'ordre de 1,35 µm, la région restante des couches 51, 52 du côté du contact de collecteur 75, une largeur de l'ordre de 0,2 µm et l'espaceur 73 une largeur de l'ordre de 0,1 µm. Le contact de collecteur se trouve donc à moins de 1 µm du centre de la région de base intrinsèque.

On va maintenant donner un exemple détaillé de réalisation du procédé selon la présente invention basé sur une technologie de type CMOS 0,25 µm à isolement BOX ou 0,35 µm à isolement LOCOS. Ce procédé comprend les étapes suivantes :
réaliser les étapes normales de fabrication des transistors CMOS jusqu'aux étapes d'implantation de drains et de sources faiblement dopés (LDD) ;
utiliser l'implantation de caisson N pour former la région de collecteur du transistor NPN ;
déposer par voie chimique en phase vapeur une couche d'oxyde (51) d'une épaisseur de l'ordre de 20 nm, et une couche de silicium polycristallin (52) d'une épaisseur de l'ordre de 50 nm ;
graver d'abord le silicium polycristallin (52) puis par gravure humide l'oxyde résiduel (51) pour éviter de dégrader la surface apparente du caisson N ;
réaliser les épitaxies décrites précédemment ;
déposer par voie chimique en phase vapeur une couche d'oxyde d'une épaisseur de l'ordre de 20 nm puis une couche de nitrure d'une épaisseur de l'ordre de 30 nm pour constituer la couche 61 de la figure 2C ;
graver sous plasma la couche de nitrure, réaliser éventuellement une implantation profonde de collecteur, et graver par voie humide la couche résiduelle d'oxyde ;
déposer la couche de silicium polycristallin d'émetteur (62) et la doper à l'arsenic in situ ou par implantation ;
déposer une couche mince (63, figure 2C) d'oxyde d'encapsulation sur une épaisseur de l'ordre de 20 nm ;
procéder aux diverses étapes décrites en relation avec les figures 3, 4A et 4B.

En plus de la simplification du procédé décrit précédemment, résultant de la suppression des couches enterrées avant l'épitaxie, la présente invention permet d'obtenir un composant de surface réduite. En effet, du fait de la suppression du puits collecteur, on évite de devoir délimiter une zone par un oxyde épais autour du puits collecteur, comme cela est illustré en figure 1.

Par ailleurs, la réalisation du contact de base sur un oxyde épais permet une réduction supplémentaire de la capacité de collecteur.

## Revendications

1. Procédé de fabrication d'un circuit intégré BICMOS comprenant un transistor NPN et un transistor MOS à canal N et un transistor MOS à canal P dans une couche (41) faiblement dopée de type P, directement formée par épitaxie sur un substrat (42) fortement dopé de type P, comprenant les étapes suivantes dans l'ordre suivant :
former un caisson (43) dopé de type N par implantation/diffusion, dans la couche (41) faiblement dopée de type P pour constituer le collecteur d'un transistor bipolaire, ce caisson ayant un niveau de dopage relativement élevé et sensiblement homogène ,
revêtir la structure d'une couche d'amorçage de silicium polycristallin (52) et ouvrir ce sandwich au-dessus de portions des caissons de collecteurs ;
procéder à la croissance épitaxiale de silicium non dopé puis à la croissance épitaxiale de silicium dopé de type P constituant au-dessus de la région de collecteur une région de base monocristalline ;
déposer une couche isolante (61) et l' ouvrir à l'emplacement de l' émetteur au-dessus de la region de base monocristalline (55) ;
déposer du silicium polycristallin d'émetteur dopé de type N (62) ;
graver silicium polycristallin d'émetteur (62) en dehors des zones utiles ;
graver le silicium de base (54) en dehors des zones utiles en laissant en place notamment une portion au-dessus d'une région d'oxyde épais ;
former des espaceurs (72, 71, 73) sur les bords de la couche de silicium polycristallin d'émetteur (62) et sur les bords de la couche de silicium de base (54) et sur les bords des portes des transistors MOS; **caracterisé par**:
procéder à une implantation de type N de prise de contact de collecteur (75) en même temps que l'implantation de drain et de source (76) des transistors MOS à canal N; et
procéder à une implantation de type P de prise de contact de base (64) en même temps que les implantations de drain et de source des transistors MOS à canal P.

2. Procédé selon la revendication 1, **caractérisé en ce que** l'épitaxie de base comprend en outre une étape d'épitaxie de silicium-germanium avec une proportion de germanium de l' ordres de 10 à 15 %, cette phase étant réalisée après, la phase de croissance de silicium non dopé.

3. Procédé selon la revendication 1, **caractérisé en ce que** le caisson de collecteur est formé en même temps que les caissons des transistors MOS à canal P.

4. Procédé selon la revendication 1, **caractérisé en ce que** la couche de silicium d'amorçage (52) est déposée sur une couche d'oxyde de silicium (51).

5. Procédé selon la revendication 1, **caractérisé en ce que** le caisson a un niveau de dopage superficiel de l'ordre de 10¹⁷ atomes/cm³.

## Claims

1. A method of manufacturing a BICMOS integrated circuit including an NPN transistor and an N-channel MOS transistor and a P-channel MOS transistor in a lightly-doped P-type epitaxial layer (41), directly epitaxied in a heavily-doped P-type substrate (42), including the following steps in the following order:
forming an N-type doped well (43) by implantation/diffusion, in the lightly doped P-type layer (41) to form the collector of a bipolar transistor, this well having a relatively high and substantially homogeneous doping level;
coating the structure with a polysilicon seed layer (52) and opening the sandwich above portions of the collector well;
epitaxially growing undoped silicon, then epitaxially growing P-type doped silicon forming above the collector region a single-crystal silicon base region;
depositing an insulating layer (61) and opening it at the location of the emitter above the single-crystal base region (55);
depositing N-type emitter polysilicon (62);
etching the emitter polysilicon (62) beyond useful areas;
etching the base silicon (54) outside the useful areas while leaving in place, in particular, a portion above a thick oxide region;
forming spacers (72, 71, 73) on the edges of the emitter polysilicon layer (62) and on the edges of the base silicon layer (54) and on the edges of the gates of the MOS transistors; **characterized by**
performing an N-type implantation of collector contact area (75) at the same time as the drain and source (76) implantation of the N-channel MOS transistors; and
performing a P-type base contact area implantation (64) at the same time as the drain and source implantations of the P-channel MOS transistors.

2. The method of claim 1, **characterized in that** the base epitaxy further includes a step of silicon-germanium epitaxy with a proportion of germanium on the order of 10 to 15%, this phase being performed after the phase of growth of undoped silicon.

3. The method of claim 1, **characterized in that** the collector well is formed at the same time as the wells of the P-channel MOS transistors.

4. The method of claim 1, **characterized in that** the seed polysilicon layer (52) is deposited on a silicon oxide layer (51).

5. The method of claim 1, **characterized in that** the well has a surface doping level on the order of 10¹⁷ atoms/cm³.

## Patentansprüche

1. Ein Verfahren zum Herstellen eines integrierten BICMOS Schaltkreises einschließlich eines NPN Transistors und eines N-Kanal MOS Transistors und eines P-Kanal MOS Transistors in einer leicht dotierten P-Typ bzw. P-leitenden expitaxialen Schicht (41), direkt epitaxial aufgebracht in einem stark dotierten P-leitenden Substrat (42), wobei das Verfahren die folgenden Schritte in der folgenden Reihenfolge aufweist:
Bilden einer N-leitenden dotierten Wanne (43) durch Einimpfung/Diffusion in der schwach dotierten P-leitenden Schicht (41) zum Bilden des Kollektors eines bipolaren Transistors, wobei diese Wanne ein relativ hohes und im Wesentlichen homogenes Dotierungsniveau besitzt;
Beschichten der Struktur mit einer Polysilizium-Keimschicht (52) und Öffnen des Sandwich bzw. der Schicht an Ordnung oberhalb von Anteilen der Kollektorwanne;
Epitaxiales Aufwachsen von undotiertem Silizium, dann epitaxiales Aufwachsen von P-leitenden dotiertem Silizium um oberhalb der Kollektorregion eine einkristallige Silizium-Basisregion zu bilden;
Abscheiden einer isolierenden Schicht (61) und Öffnen dieser an der Stelle des Emitters oberhalb der einkristalligen Basisregion (55);
Abscheiden von N-leitendem Emitter-Polysilizium (62);
Ätzen des Emitter-Polysiliziums (62) jenseits von nützlichen Arealen;
Ätzen des Basis-Siliziums (54) außerhalb der nützlichen Areale während im Speziellen ein Teil oberhalb einer dicken Oxydregion am Platz verbleibt;
Bilden von Abstandshaltern (72, 71, 73) an den Kanten der Emitter-Polysilizium-Schicht (62) und an den Kanten von der Basis-Silizium-Schicht (54) und an den Kanten von den Gattern der MOS Transistoren;
**gekennzeichnet durch**
Durchführen einer N-leitdenden Einimpfung eines Kollektorkontaktareals (75) zur gleichen Zeit wie die Drain- und Source-(76)-Einimpfung der N-Kanal MOS Transistoren; und
Durchführen einer P-leitdenden Basiskontaktareal-Einimpfung (64) zur gleichen Zeit wie die Drain- und Source-Einimpfungen der P-Kanal MOS Transistoren.

2. Verfahren nach Anspruch 1, **gekennzeichnet dadurch dass** die Basis-Epitaxie ferner einen Schritt mit Silizium-Germanium-Epitaxie aufweist und zwar mit einem Anteil von Germanium in der Größenordnung von 10 bis 15 %, wobei diese Phase nach der Phase des Wachsens von undotiertem Silizium durchgeführt wird.

3. Verfahren nach Anspruch 1, **gekennzeichnet dadurch dass** die Kollektorwanne zur gleichen Zeit gebildet wird, wie die Wannen der P-Kanal MOS Transisitoren.

4. Verfahren nach Anspruch 1, **dadurch gekennzeichnet dass** die Keim-Polysilizium-Schicht (52) auf einer Silizium-Oxid-Schicht (51) abgeschieden wird.

5. Verfahren nach Anspruch 1, **dadurch gekennzeichnet, dass** die Wanne ein Oberflächen-Dotierungsniveau in der Größenordnung von 10¹⁷ Atome/cm³ besitzt.
